# EUROPÄISCHE PATENTSCHRIFT

(11) **EP 0 964 281 B1**
(45) Veröffentlichungstag und Bekanntmachung des Hinweises auf die Patenterteilung: **01.07.2009**
(21) Anmeldenummer: 99110271.6
(22) Anmeldetag: 27.05.1999
(51) Int. Cl.: G02B 7/02, G03F 7/20

(54) **Baugruppe aus optischem Element und Fassung**
Assembly comprising an optical element and its mounting
Ensemble comportant un élément optique et sa monture

(30) Priorität: 09.06.1998 DE 19825716
(43) Veröffentlichungstag der Anmeldung: 15.12.1999
(60) Teilanmeldung: 08171077.4
(73) Patentinhaber: Carl Zeiss SMT AG, 73447 Oberkochen (DE)
(72) Erfinder: Holderer, Hubert, 89551 Königsbronn (DE); Rümmer, Peter, 73447 Oberkochen (DE); Trunz, Michael, 73479 Ellwangen (DE)
(74) Vertreter: Schultz, Jörg Martin

(56) Entgegenhaltungen:
- EP-A- 0 053 463
- EP-A- 0 230 277
- DE-A- 3 116 579
- DE-A- 3 714 745
- US-A- 5 428 482
- US-A- 5 457 577
- US-A- 5 523 893
- PATENT ABSTRACTS OF JAPAN vol. 010, no. 097 (P-446), 15. April 1986 (1986-04-15) & JP 60 230609 A (KONISHIROKU SHASHIN KOGYO KK), 16. November 1985 (1985-11-16)
- PATENT ABSTRACTS OF JAPAN vol. 199, no. 805, 30. April 1998 (1998-04-30) & JP 10 026736 A (SANYO ELECTRIC CO LTD), 27. Januar 1998 (1998-01-27)

## Beschreibung

Die Erfindung betrifft eine Baugruppe aus optischem Element und Fassung, die Verwendung einer solchen Baugruppe, ein Objektiv damit und eine Projektionsbelichtungsanlage der Mikrolithographie damit. Optische Bauelemente, z.B. Linsen, Prismen, Spiegel, Gitter, vielfach aus Glas, Kristall oder Keramik bestehend, werden regelmäßig mittels Fassungen, in der Regel aus Metall, zu optischen Baugruppen, zum Beispiel Objektiven, zusammengebaut.

Dabei sind die optischen Elemente unter Einhaltung enger Toleranzen relativ zueinander zu positionieren und die ganze Baugruppe soll eine gewisse Robustheit gegenüber Umwelteinflüssen aufweisen. Besondere Anforderungen werden dabei sowohl bei astronomischen Teleskopen, wie bei satellitengestützten Systemen (Beispiel ROSAT-Röntgenteleskop) und bei Projektionsbelichtungssystemen der Mikrolithographie gestellt.

EP 0 053 463 lehrt die Aufhängung von Präzisionsspiegeln an Blattfederelementen, die angeklebt werden.

Eine hochentwickelte Fassungstechnik für Linsen von Mikrolithographie-Projektionsobjektiven ist auch in US 5,428,482 beschrieben.

Entweder wird die Linse direkt mit drei radialen Biegebalken verklebt, oder ein Zwischenring ist über drei am Umfang gleichverteilte Festkörpergelenke mit einem äußeren Fassungsring verbunden. Vollflächige Verklebung von Linse und Zwischenring ist vorgesehen. Durch Stapeln der Fassungsringe wird dann die optische Baugruppe, insbesondere ein Objektiv, aufgebaut.

Anordnungen mit Aktuatoren zur Verlagerung oder Deformation optischer Elemente relativ zum Fassungs-Basisteil sind in vielfältiger Ausführung bekannt. Ein Beispiel gibt EP 0 145 902 A, wo ein Spiegel über drei tangentiale Speichen an einer Fassung aufgehängt ist, die durch Peltierelemente in ihrer Länge verändert werden können.

Aufgabe der Erfindung ist die Bereitstellung einer Baugruppe aus optischem Element und Fassung, bei der die Genauigkeit der Positionierung des optischen Elements und seine Entkopplung von auf die Fassung wirkenden Umwelteinflüssen gesteigert sind. Die Fügestelle zwischen optischem Element und Fassung, also in der Regel eine Glas-Metall- oder Kristall-Metall-Verbindung, soll gleichzeitig von Anforderungen an die geometrische Präzision entlastet werden, um sie für andere Fügeverfahren als Kleben hauptsächlich wegen der DUV-Beständigkeit zugänglich zu machen.

Die erfinderische Lösung soll als Konstruktionsprinzip eine große Bandbreite von Anwendungsfällen abdecken. Die Integration in ein Objektiv und die Verwendung in einer Mikrolithographie-Projektionsbelichtungsanlage ist vorgesehen, mit besonderer Eignung zur sehr feinfühligen Regelung von dessen Abbildungsleistung.

Gelöst wird diese Aufgabe durch eine Baugruppe nach Anspruch 1.

Damit wird im wesentlichen die unterschiedliche Wärmeausdehnung vom optischem Element (z.B. Glas) und Fassung (Metall) aufgenommen. Insgesamt werden Spannungen minimiert.

Vorteilhafte Ausführungsformen sind Gegenstand der Unteransprüche 2 bis 15. Gemäß Anspruch 2 sind die Laschen als Blattfedern angelegt.

Bei einer Ausführung der Verbindung des optischen Elements mit den Laschen geht es darum, Stabilität gegen die Strahlung mit der das optische Element beaufschlagt wird zu sichern - was bei Klebungen im UV-Bereich ein Problem ist - und gleichzeitig keine Spannungen im optischen Element aufzubauen, wie das bei formschlüssigen Verbindungen (Klemmung) unvermeidbar ist. Metallische Schweiß-oder Lötverbindungen werden daher bevorzugt.

Gemäß den Ansprüchen 3 bis 4 gilt ähnliches für die Verbindung der Laschen mit dem Zwischenring, wobei hier auch die homogene einstückige Ausführung nach Anspruch 3 möglich und in vielen Fällen sinnvoll ist. Wo jedoch Lagetoleranzen der Laschen an der Verbindung zum optischen Element auszugleichen sind, ist die Fügung an den Zwischenring durch Laserschweissen vorteilhaft.

Für die passiven Entkoppler sind in erster Linie Festkörpergelenke und -getriebe geeignet, etwa entsprechend US 5,428,482.

Eine bedeutende Klasse von optischen Elementen sind die nach Anspruch 5 vorgesehenen mit rotationssymmetrischem Rand mit einer Symmetrieachse. Dies umfaßt insbesondere die klassischen Linsen mit zylindrischem Rand, durchaus auch mit nicht sphärischen und nicht zentrierten optischen Flächen.

Dafür geben die Ansprüche 6 bis 8 vorteilhafte Ausführungen des Zwischenrings und der Laschen an.

Anspruch 9 gibt eine weitere Klasse von optischen Elementen an - die in Anspruch 5 beschriebene ist darin enthalten - mit denen besonders vorteilhafte Ausführungen u.a. nach den Ansprüchen 10 und 11 hinsichtlich der Laschenanordnung möglich sind. Die Laschen sind danach wie Speichen zwischen dem optischen Element "Nabe" und dem Zwischenring "Felge" angeordnet.

Nach Anspruch 12 sind die Laschen ähnlich wie die Balken der US 5,428,482 tangential angeordnet.

Anspruch 13 beschreibt einen wesentlichen Vorteil der erfindungsgemäßen Anordnung, die mit ihren vielen freien Konstruktionsparametern gut die Einstellung einer niedrigsten Eigenfrequenz mechanischer Schwingungen größer als 200 bis 400 Hz ermöglicht. Damit werden die im wesentlichen bei niedrigeren Frequenzen vorliegenden störenden Schwingungsanregungen wirksam unterdrückt.

Ansprüche 14 und 15 dokumentieren die mit der Erfindung erreichbare hohe Güte der spannungsfreien Lagerung. Es werden astigmatische bzw. 3 wellige Rest-Linsendeformationen unter 30 nm, bis unter 20 nm, erreicht. Die Deformationen der Auflagefläche des Außenrings werden zu über 95 %, vorzugsweise über 98 % und in optimalen Konstruktionen zu über 99 % von der Linse entkoppelt.

In ihrem bevorzugten Einsatz sind die Baugruppen gemäß den Ansprüchen 16 bis 17 in Objektiven und Projektionsbelichtungsanlagen der Mikrolithographie.

Näher erläutert wird die Erfindung anhand der Zeichnungen.
- Figur 1: zeigt einen schematischen Schnitt durch eine Anordnung mit hängenden Laschen und Aktuator;
- Figur 2: zeigt einen schematischen Schnitt durch eine erfindungsgemäße Anordnung mit liegenden Laschen und Festkörpergelenk zwischen Zwischenring und Fassung;
- Figur 3: zeigt eine Aufsicht auf eine Anordnung nach Art der Figur 2;
- Figur 4: zeigt eine Aufsicht auf eine Anordnung mit tangentialen Laschen;
- Figur 5: zeigt einen schematischen Schnitt durch eine Anordnung mit Spiegel und Aktuator mit Hebelgetriebe;
- Figur 6: zeigt schematisch eine Projektionsbelichtungsanlage;
- Figur 7: schematisch eine bevorzugte Federlasche.

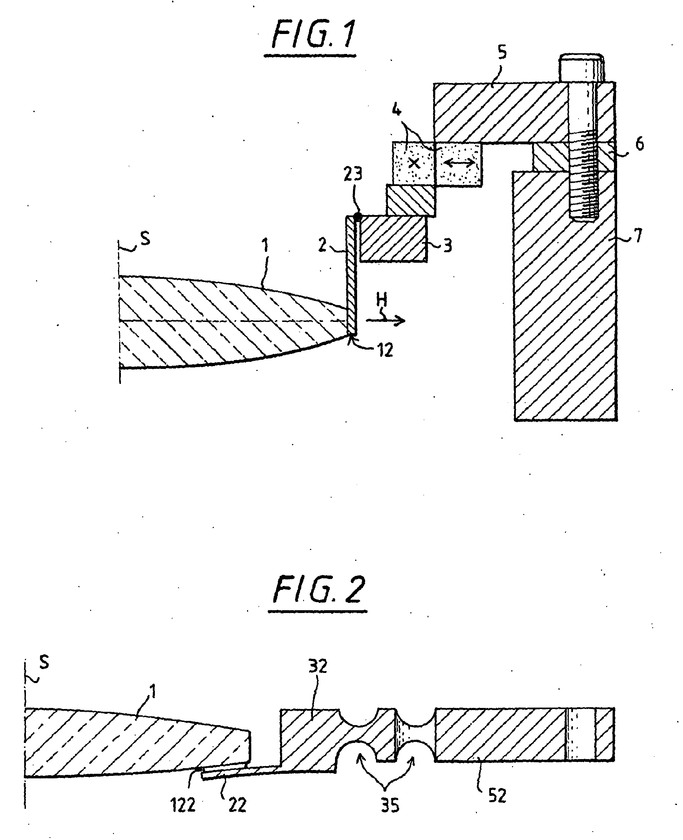

Die in Figur 1 dargestellte Anordnung weist eine Linse 1 und eine Fassung 5 auf. Es ist ein steifer Zwischenring 3 - z.B. ein Edelstahlring von (größenordnungsmäßig) 1 cm² Querschnitt abhängig von Masse und Steifigkeit der Linse - vorgesehen, der über Laschen 2 mit der Linse 1 und über Aktuatoren 4 mit der Fassung 5 verbunden ist. Über eine Zwischenlage 6, die der exakten Höhenjustage dient, ist die Fassung an ein Gehäuse 7 angeschlossen, das z.B. als Abstandsring zu einer weiteren derart gefaßten Linse ausgebildet ist.
¹⁾ ES

Die Verbindung 12 der Linse 1 mit den Laschen 2 ist aus zwei Gründen problematisch:
Erstens ist die Werkstoffpaarung durch die unterschiedlichen Eigenschaften des optischen Elements 1 aus Glas, aus Kristallen wie CaF₂ oder Quarz oder aus Glaskeramik (Zerodur(R)-Spiegel) und der Metall-Laschen 2 aus Edelstahl, Federbronze oder dergleichen beim Schweißen, Löten aber auch beim Schrauben oder Nieten problembehaftet.
Zweitens ist diese Fügestelle durch die Strahlung, zu deren Transport das optische Element da ist, belastet - mit Ausnahmen bei Spiegeln -. Bei Anwendungen im tiefen UV-Spektralbereich (etwa 300 - 100 nm Wellenlänge) führt dies zur weitgehenden Unbrauchbarkeit organischer Kleber, da diese durch die Strahlung zerstört werden.
Daneben ist diese Verbindung 12 mit sehr engen geometrischen Toleranzen auszuführen, um den Zweck der Anordnung zu erreichen.

Weiter sind die optischen Elemente 1 empfindlich gegen thermische Belastungen, da beispielsweise Antireflexbeschichtungen Temperaturen deutlich über 100° C nicht vertragen und andererseits Gläser und besonders Kristalle wie CaF₂ - das wegen seiner DUV-Transparenz als Partner zu Quarzglas für achromatisierte Optiken benötigt wird - empfindlich gegen zeitliche und räumliche Temperaturgradienten sind.

Im Beispiel ist die Verbindung 12 durch eine Ultraschallschweißung, wie sie beispielsweise aus E. Röder et al., Technologie & Management 44 (1995), Seite 31-39 bekannt ist, hergestellt, womit die o.g. Probleme beherrscht werden können. Eine andere mögliche Fügetechnik ist das Löten mit niedrigschmelzenden Loten wie in DE 197 55 356 dargestellt. Positionstoleranzen der Laschen 2 können durch die Kopplung 25 der Laschen an den steifen Zwischenring aufgefangen werden, wenn diese anschließend ausgeführt wird. Dafür hat sich das Laserschweißen als geeignet gezeigt, wodurch bei geringem Wärmeeintrag sehr gleichmäßige Schweißverbindungen erzielt werden.

Die Laschen 2 sind als Blattfederelemente aus Blech durch Stanzen oder Ätzen präzise geformt. Sie sind typisch 0,1 mm bis 0,5 mm dick, ca 3-20 mm breit und 10-30 mm lang, bei einem Abstand von einigen mm. Im Beispiel sind sie parallel zur optischen Achse und Symmetrieachse der Linse 1 angeordnet.

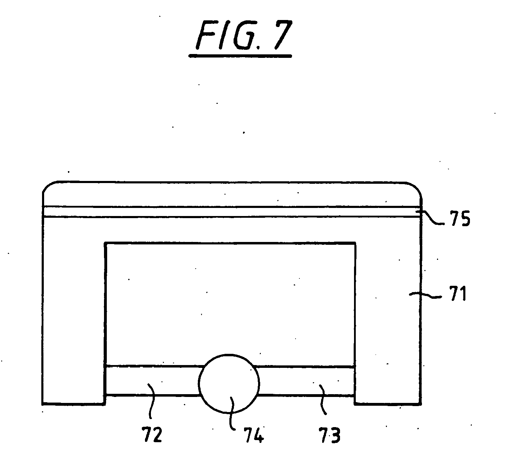

Eine Ausführung nach Figur 7, ein Ätz- oder Stanzteil mit steifem Bügel 71, zwei tangentialen Blattfederelementen 72, 73 und Zone 74 zum Ultraschallverschweißen mit der Linse dazwischen ergibt momentenfreie radiale Ausdehnungsmöglichkeit der Linse. Mit 75 ist die Laser-Schweißzone zur Verbindung mit dem Zwischenring bezeichnet.

An zum Beispiel drei über den Umfang gleichverteilten Stellen ist der steife Zwischenring 3 über Aktuatoren 4 mit der Fassung 5 verbunden. Die Aktuatoren 4 sind z.B. aus piezoelektrischen Elementen aufgebaut. Durch diese Anordnung werden zwei Freiheitsgrade der Linse 1 gegenüber der Fassung 5 entkoppelt, nämlich die Kippungen um die x- und y-Achsen senkrecht zur Symmetrieachse 5.

Passive Aktuatoren die nur bei der Justage des Objektives benötigt werden, können auch durch Stellschrauben betätigt werden.

Dies ermöglicht einerseits eine Justierung der Linsenkippung und entkoppelt andererseits Deformationen der Fassung 5, die beim Zusammenbau der Fassungen 5, Zwischenlagen 6 und Gehäuse 7 zu kompletten optischen Systemen - z.B. Objektiven - aus deren Fertigungstoleranzen usw. entstehen.

Figur 2 zeigt in entsprechender Darstellung eine Variante. Hier ist die Linse 1 durch eine Klebestelle 122 mit den Laschen 22 verbunden. Bei Anwendung einer Kleberschutzschicht nach DE 197 48 211 ist die Strahlungsbeständigkeit des Klebers gesichert. Die bekannte Methode des Richtkittens ermöglicht dabei eine sehr genaue Justage.

Die Laschen 22 sind mit dem steifen Ring 32 vereinigt aus einem Stück gefertigt, wobei z.B. zum Präzisionsdrehen zusätzlich das Erodieren zum Einbringen der Trennungen zwischen den Laschen 22 eingesetzt wird. Durch Festkörpergelenke 35 ist der steife Ring von der Fassung 52 entkoppelt, so daß sich deren Verformungen im Einbauzustand nicht auf die Linse 1 auswirken können.

Die typischen Abmessungen sind gleich wie bei Figur 2.

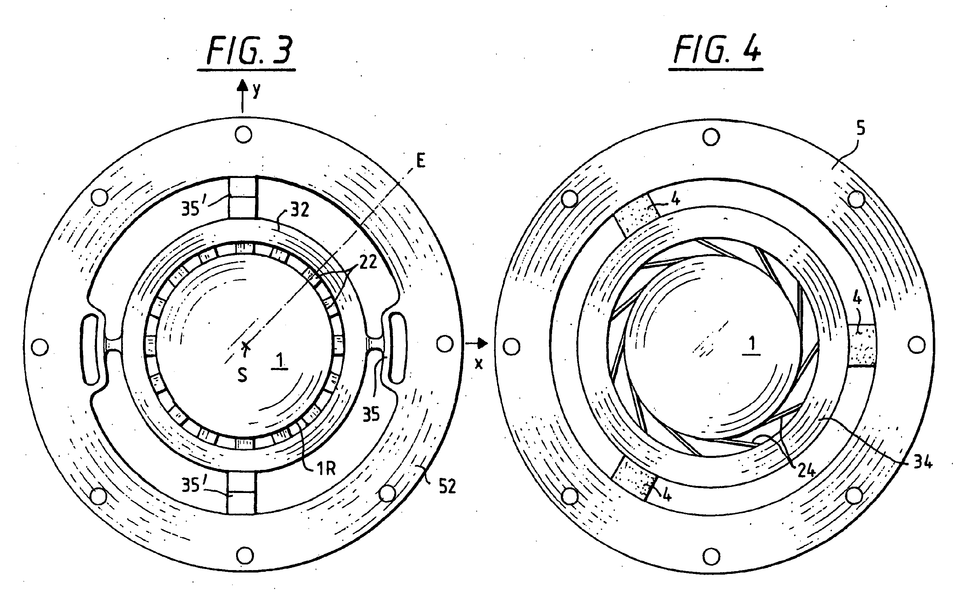

Figur 3 zeigt eine Ansicht der in Figur 2 im Querschnitt gezeigten Anordnung in Richtung der optischen Achse und Symmetrieachse S. Man sieht, daß die Laschen 22 radial angeordnet sind und jeweils zu einer Ebene E symmetrisch ausgebildet sind, welche die Symmetrieachse S enthält (Anspruch 17) . Auch hat das optische Element 1 (Linse) einen zur Symmetrieachse S rotationssymmetrischen Rand 1R, der Zwischenring 32 ist ein zur Symmetrieachse S rotationssymmetrischer Ring (Anspruch 16), und die Laschen 22 sind über den Umfang gleichverteilt (Anspruch 18). Auf der X-Achse und der Y-Achse liegen jeweils Federgelenke 35, 35', deren Beweglichkeit jeweils paarweise verschieden orientiert ist. Der Fassungskonstrukteur wählt Anzahl, Lage und Beweglichkeit nach den gegebenen Beanspruchungen aus. Auch die Fassung 52 ist hier wie im allgemeinen bei Linsenfassungen zylindrisch.

Figur 4 zeigt in gleicher Aufsicht eine Anordnung mit tangential an die Linse 1 angreifenden Laschen 24, die hier auch senkrecht zur Zeichenebene stehen und damit senkrecht zur Hauptebene X, Y mit x- und y-Achse stehen - wie auch die hängenden Laschen der Figur 1 -. Der Zwischenring 34 ist hier über drei unter jeweils 120° angeordnete Aktuatoren 4 der zu Figur 1 beschriebenen Bauart mit der Fassung 5 verbunden.

Die erfindungsgemäße Anordnung eignet sich natürlich nicht nur für rotationssymmetrische Linsen wie in oben stehenden Beispielen, sondern für jede Art optischer Elemente wie Prismen, Spiegel, Gitter, holographische Elemente usw. jeder Form. Beachtlich ist, daß diese Fassungstechnik für beliebige Lagen des optischen Elements relativ zur Schwerkraft geeignet ist.

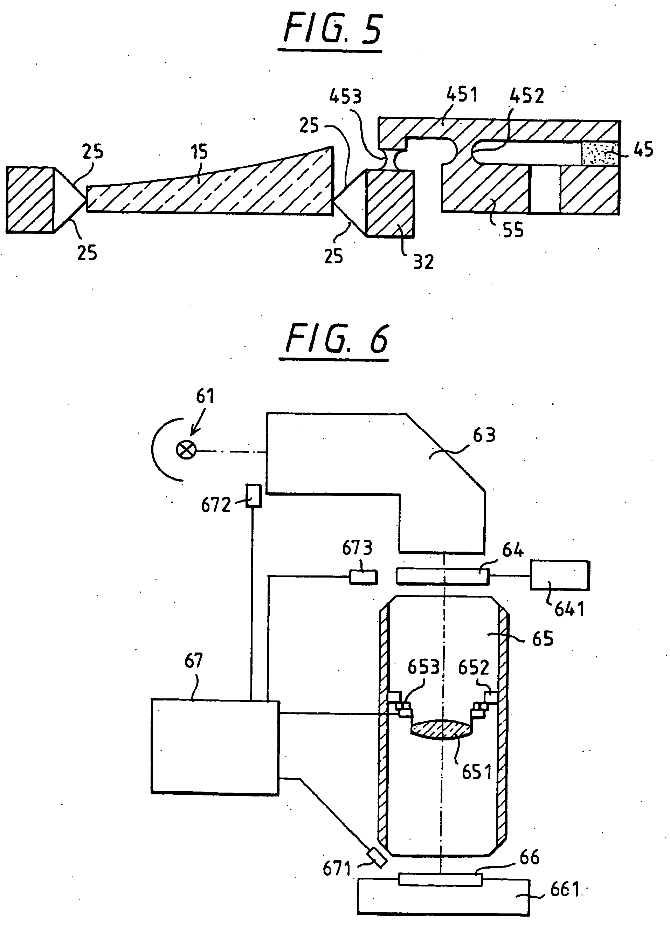

Als Beispiel zeigt Figur 5 einen dezentrierten Zylinderspiegel 15, der mit paarweise schrägstehenden Federlaschen 25 an den Zwischenring 32 angebunden ist. Über die Festkörpergelenke 452, 453 und den Hebel 451 ist der steife Zwischenring an die Fassung 55 gekoppelt. Der Aktuator 45 (z.B. piezoelektrisch, oder durch ein Peltierelement gesteuertes Ausdehnungselement vgl. EP 0 145 902 A) wirkt so über das Hebelgetriebe 451, 452, 453 mit Untersetzung auf den Zwischenring 35.

Figur 6 zeigt schließlich beispielhaft die Unterbringung einer in einer Fassung 652 angeordneten Linse 651 in einem Objektiv 65, das als Projektionsobjektiv Teil einer Mikrolithographie-Projektionsbelichtungsanlage ist. Diese besteht wie bekannt aus einer Lichtquelle 61, einem Beleuchtungssystem 63, einer Maske 64 mit einem Positioniersystem 641, dem Objektiv 65, dem Wafer 66 und dessen Positioniersystem 661.

Natürlich sind in der Regel im Objektiv 65 mehrere Linsen, bei einem katadioptrischen oder katoptrischen Objektiv auch Spiegel, erfindungsgemäß gefaßt. Hier ist aber aus Gründen der Klarheit nur eines gezeigt. Ebenso kann diese Fassungtechnik natürlich auch im Beleuchtungssystem 63 Verwendung finden.

Ein Leitsystem 67 der Projektionsbelichtungsanlage mit Sensoren 671, 672, 673 steuert die Aktuatoren 653 an der Fassung 652.

Abhängig von Bildparametern (Sensor 671) wie Fokuslage, Wellenfront und dergleichen, von Beleuchtungsparametern (Sensor 672) wie Pulsdauer, Zahl, Beleuchtungseinstellung wie Kohärenzgrad, Quadrupolbeleuchtung, und/oder von Parametern der Maske (Sensor 673) regelt das Leitsystem 67 durch ansteuern der Aktuatoren 653 wie auch ggf. der Aktuatoren anderer optischer Elemente die optimale Bildqualität, wobei in der Regel im Leitsystem 67 abgelegte Kennfelder und Kalibrierparameter Verwendung finden.

## Patentansprüche

1. Baugruppe aus optischem Element (1), Fassung (5) und steifem Zwischenring (3, 32), wobei der steife Zwischenring (3, 32) über passive Entkoppler (35), die Festkörpergelenke enthalten, mit der Fassung (5) zum Anschluß an ein Gehäuse (7) und/oder an weitere Fassungen verbunden ist,
**dadurch gekennzeichnet, daß**
das optische Element (1) stoffschlüssig mit einer Mehrzahl von Laschen (2, 22) verbunden ist, die mit dem steifen Zwischenring (3, 32) gekoppelt sind, und als Federgelenke zur Aufnahme einer unterschiedlichen Wärmeausdehnung von optischem Element (1) und Fassung (5) ausgebildet sind.

2. Baugruppe nach Anspruch 1, **dadurch gekennzeichnet, dass** die Federgelenke als Blattfedern ausgelegt sind.

3. Baugruppe nach mindestens einem der Ansprüche 1 bis 2, **dadurch gekennzeichnet, dass** die Laschen (2, 22) mit dem Zwischenring (3, 32) einen einteiligen Körper bilden.

4. Baugruppe nach mindestens einem der Ansprüche 1 bis 2, **dadurch gekennzeichnet, dass** die Laschen (2, 22) stoffschlüssig an den Zwischenring (3, 32) gekoppelt sind.

5. Baugruppe nach mindestens einem der Ansprüche 1 bis 4, **dadurch gekennzeichnet, dass** das optische Element (1) einen rotationssymmetrischen Rand mit einer Symmetrieachse (S) aufweist.

6. Baugruppe nach Anspruch 5, **dadurch gekennzeichnet, dass** der Zwischenring (3, 32) zur Symmetrieachse (S) rotationssymmetrisch ist.

7. Baugruppe nach Anspruch 5 oder 6, **dadurch gekennzeichnet, dass** die Laschen (2) symmetrisch zu die Symmetrieachse enthaltenden Ebenen (E) ausgebildet sind.

8. Baugruppe nach mindestens einem der Ansprüche 5 bis 7, **dadurch gekennzeichnet, dass** die Laschen (2) gleichmäßig über den Umfang des optischen Elements (1) verteilt angeordnet sind.

9. Baugruppe nach mindestens einem der Ansprüche 1 bis 8, **dadurch gekennzeichnet, dass** das optische Element (1) eine Haupt-Ebene (H) aufweist, welche sein Rand mit einer geschlossenen Kurve durchstößt.

10. Baugruppe nach Anspruch 9, **dadurch gekennzeichnet, dass** die Laschen (2) im wesentlichen senkrecht zur Haupt-Ebene (H) angeordnet sind.

11. Baugruppe nach Anspruch 10, **dadurch gekennzeichnet, dass** die Laschen (22) im wesentlichen in der Haupt-Ebene (H) radial zum Rand des optischen Elements (1) angeordnet sind.

12. Baugruppe nach einem der Ansprüche 1 bis 10, **dadurch gekennzeichnet, dass** die Laschen (22) im wesentlichen tangential zum Rand (1R) des optischen Elements (1) angeordnet sind.

13. Baugruppe nach einem der Ansprüche 1 bis 12, **dadurch gekennzeichnet, dass** die niedrigste Eigenfrequenz mechanischer Schwingungen größer als 200 Hz, vorzugsweise größer als 300 Hz, bis etwa 1 KHz ist.

14. Baugruppe nach einem der Ansprüche 1 bis 13, **dadurch gekennzeichnet, dass** die astigmatische und die dreiwellige Deformation der optischen Elements (1) unter 30 nm liegt.

15. Baugruppe nach einem der Ansprüche 1 bis 14, **dadurch gekennzeichnet, dass** die Deformationen der Auflagefläche des Außenrings (5) zu über 95 % vom optischen Element (1) entkoppelt sind.

16. Objektiv (65) enthaltend zumindest eine Baugruppe nach mindestens einem der Ansprüche 1 bis 15.

17. Verwendung einer Baugruppe nach mindestens einem der Ansprüche 1 bis 15 zum Aufbau einer Mikrolithographie-Projektionsbelichtungsanlage.

## Claims

1. Assembly comprising an optical element (1), mount (5) and rigid intermediate ring (3, 32), the rigid intermediate ring (3, 32) being connected, by passive decouplers (35) which include solid body joints, to the mount (5) in order to connect to a housing (7) and/or to further mounts, **characterized in that** the optical element (1) is bonded to a plurality of lugs (2, 22) which are coupled to the rigid intermediate ring (3, 32) and are designed as spring joints in order to absorb a different thermal expansion of optical element (1) and mount (5).

2. Assembly according to Claim 1, **characterized in that** the spring joints are designed as leaf springs.

3. Assembly according to at least one of Claims 1 to 2, **characterized in that** the lugs (2, 22) form a unipartite body together with the intermediate ring (3, 32).

4. Assembly according to at least one of Claims 1 to 2, **characterized in that** the lugs (2, 22) are bonded to the intermediate ring (3, 32).

5. Assembly according to at least one of Claims 1 to 4, **characterized in that** the optical element (1) has a rotationally symmetrical edge with an axis of symmetry (S).

6. Assembly according to Claim 5, **characterized in that** the intermediate ring (3, 32) is rotationally symmetrical with respect to the axis of symmetry (S).

7. Assembly according to Claim 5 or 6, **characterized in that** the lugs (2) are designed symmetrically with respect to planes (E) containing the axis of symmetry.

8. Assembly according to at least one of Claims 5 to 7, **characterized in that** the lugs (2) are arranged in a uniformly distributed fashion over the circumference of the optical element (1).

9. Assembly according to at least one of Claims 1 to 8, **characterized in that** the optical element (1) has a principal plane (H) which intersects its edge with a closed curve.

10. Assembly according to Claim 9, **characterized in that** the lugs (2) are arranged substantially perpendicular to the main plane (H).

11. Assembly according to Claim 10, **characterized in that** the lugs (22) are arranged substantially in the main plane (H) in a radial fashion relative to the edge of the optical element (1).

12. Assembly according to one of Claims 1 to 10, **characterized in that** the lugs (22) are arranged substantially tangentially to the edge (1R) of the optical element (1).

13. Assembly according to one of Claims 1 to 12, **characterized in that** the lowest natural frequency of mechanical oscillations is greater than 200 Hz, preferably greater than 300 Hz, up to approximately 1 kHz.

14. Assembly according to one of Claims 1 to 13, **characterized in that** the astigmatic and the third-order deformation of the optical element (1) is below 30 nm.

15. Assembly according to one of Claims 1 to 14, **characterized in that** the deformations of the seating surface of the outer ring (5) are decoupled to above 95% from the optical element (1).

16. Objective (65) including at least one assembly according to at least one of Claims 1 to 15.

17. Use of an assembly according to at least one of Claims 1 to 15 in order to construct a microlithography projection exposure machine.

## Revendications

1. Sous-ensemble constitué d'un élément optique (1), d'une monture (5) et d'une bague intermédiaire rigide (3, 32), la bague intermédiaire rigide (3, 32) étant reliée à la monture (5) destinée au raccordement à un boîtier (7) et/ou à d'autres montures par le biais d'éléments de découplage passifs (35) qui contiennent des articulations monolithiques, **caractérisé en ce que** l'élément optique (1) est relié par fusion de matières avec une pluralité de languettes (2, 22) qui sont accouplées avec la bague intermédiaire rigide (3, 32) et sont réalisées sous la forme d'articulations flexibles pour absorber les dilatations thermiques différentes de l'élément optique (1) et de la monture (5).

2. Sous-ensemble selon la revendication 1, **caractérisé en ce que** les articulations flexibles sont réalisées sous la forme de ressorts à lame.

3. Sous-ensemble selon au moins l'une des revendications 1 à 2, **caractérisé en ce que** les languettes (2, 22) forment avec la bague intermédiaire (3, 32) un corps monobloc.

4. Sous-ensemble selon au moins l'une des revendications 1 à 2, **caractérisé en ce que** les languettes (2, 22) sont accouplées par fusion de matières à la bague intermédiaire (3, 32).

5. Sous-ensemble selon au moins l'une des revendications 1 à 4, **caractérisé en ce que** l'élément optique (1) présente un bord à symétrie rotationnelle avec un axe de symétrie (S).

6. Sous-ensemble selon la revendication 5, **caractérisé en ce que** la bague intermédiaire (3, 32) est à symétrie rotationnelle par rapport à l'axe de symétrie (S).

7. Sous-ensemble selon la revendication 5 ou 6, **caractérisé en ce que** les languettes (2) sont réalisées symétriques par rapport au plan (E) qui contient l'axe de symétrie.

8. Sous-ensemble selon au moins l'une des revendications 5 à 7, **caractérisé en ce que** les languettes (2) sont distribuées régulièrement sur le pourtour de l'élément optique (1).

9. Sous-ensemble selon au moins l'une des revendications 1 à 8, **caractérisé en ce que** l'élément optique (1) présente un plan principal (H) qui transperce son bord avec une courbe fermée.

10. Sous-ensemble selon la revendication 9,
**caractérisé en ce que** les languettes (2) sont pour l'essentiel disposées perpendiculaires au plan principal (H).

11. Sous-ensemble selon la revendication 10,
**caractérisé en ce que** les languettes (22) sont pour l'essentiel disposées radialement dans le plan principal (H) par rapport au bord de l'élément optique (1).

12. Sous-ensemble selon une des revendications 1 à 10, **caractérisé en ce que** les languettes (22) sont pour l'essentiel disposées tangentiellement par rapport au bord (1R) de l'élément optique (1).

13. Sous-ensemble selon une des revendications 1 à 12, **caractérisé en ce que** la fréquence propre la plus faible des oscillations mécaniques est supérieure à 200 Hz, de préférence supérieure à 300 Hz, jusqu'à environ 1 kHz.

14. Sous-ensemble selon une des revendications 1 à 13, **caractérisé en ce que** la déformation astigmatique et à triple onde de l'élément optique (1) est inférieure à 30 nm.

15. Sous-ensemble selon une des revendications 1 à 14, **caractérisé en ce que** les déformations de la surface d'appui de la bague extérieure (5) sont découplées à plus de 95 % de l'élément optique (1).

16. Objectif (65) contenant au moins un sous-ensemble selon au moins l'une des revendications 1 à 15.

17. Utilisation d'un sous-ensemble selon au moins l'une des revendications 1 à 15 pour construire un équipement d'éclairage pour projection de microlithographie.
